# EUROPEAN PATENT APPLICATION

(11) **EP 4 250 316 A1**
(43) Date of publication of application: **27.09.2023**
(21) Application number: 21894520.2
(22) Date of filing: 09.11.2021
(51) Int. Cl.: H01C 17/22, H05K 1/16, H05K 3/28

(54) **CIRCUIT BOARD AND ELECTRONIC DEVICE**

(30) Priority: 17.11.2020 JP 2020191047
(71) Applicant: Kyocera Corporation, Kyoto-shi Kyoto 612-8501 (JP)
(72) Inventor: KURAMOTO, Yoshio, Kyoto-shi, Kyoto 612-8501 (JP)
(74) Representative: Viering, Jentschura & Partner mbB Patent- und Rechtsanwälte
(86) International application number: PCT/JP2021/041230
(87) International publication number: WO 2022/107646

(57) **Abstract**

A circuit substrate (10, 10A, 10B) according to the present disclosure includes a substrate body (11), a pair of electrodes (41, 42), a resistor (60, 60A), and a glass layer (70, 70A). The substrate body is made of a ceramic. The pair of electrodes (41, 42) are spaced apart from each other on the substrate body (11). Each of the resistors (60, 60A) is located so as to extend over the pair of electrodes (41, 42). The glass layer (70, 70A) covers the pair of electrodes (41, 42) and the resistor (60, 60A). The resistor (60, 60A) contains lanthanum hexaboride. A thickness of the glass layer (70, 70A) at an outer peripheral portion of the resistor (60, 60A) is greater than the glass layer (70, 70A) at a center portion of the resistor (60, 60A).

## Description

### TECHNICAL FIELD

The present disclosure relates to a circuit substrate and an electronic device.

### BACKGROUND OF INVENTION

Since a substrate made of a ceramic has superior insulating properties and superior thermal conductivity, the substrate may be utilized as a circuit substrate.

Patent Document 1 discloses a wiring substrate including a resistor extending over a first wiring layer and a second wiring layer, and including a glass layer (overcoat glass) covering the first wiring layer, the second wiring layer, and the resistor. Patent Document 1 discloses a technique for adjusting a resistance value of the resistor by trimming a part of the resistor.

### CITATION LIST

### PATENT LITERATURE

Patent Document 1: JP 2000-208895 A

### SUMMARY

A circuit substrate according to one aspect of the present disclosure includes a substrate body, a pair of electrodes, a resistor, and a glass layer. The substrate body is made of a ceramic. The pair of electrodes are spaced apart from each other on the substrate body. The resistor is located over the pair of electrodes. The glass layer covers the pair of electrodes and the resistor. The resistor contains lanthanum hexaboride. A thickness of the glass layer at an outer peripheral portion of the resistor is greater than a thickness of the glass layer at a center portion of the resistor.

### BRIEF DESCRIPTION OF THE DRAWINGS

FIG. 1 is a schematic side view of a lighting device according to a first embodiment.
FIG. 2 is a schematic perspective view of a socket according to the first embodiment.
FIG. 3 is a schematic plan view of a circuit substrate according to the first embodiment.
FIG. 4 is a schematic cross-sectional view taken along line IV-IV in FIG. 3.
FIG. 5 is a schematic cross-sectional view of a circuit substrate according to a second embodiment.
FIG. 6 is a schematic cross-sectional view of a circuit substrate according to a third embodiment.

### DESCRIPTION OF EMBODIMENTS

Modes (hereinafter, referred to as "embodiments") for implementing a circuit substrate and an electronic device according to the present disclosure will be described in detail below with reference to the drawings. Note that the embodiments described below are not intended to limit the circuit substrate and the electronic device according to the present disclosure. In addition, embodiments can be appropriately combined so as not to contradict each other in terms of processing content. In the following embodiments, the same portions are denoted by the same reference signs, and overlapping explanations are omitted.

In the embodiments described below, expressions such as "constant", "orthogonal", "vertical", and "parallel" may be used, but these expressions do not need to be exactly "constant", "orthogonal", "vertical", and "parallel". In other words, each of the above-described expressions allows for deviations in, for example, manufacturing accuracy, positioning accuracy, and the like.

In each of the drawings referred to below, for ease of explanation, an X-axis direction, a Y-axis direction, and a Z-axis direction that are orthogonal to each other may be defined to illustrate a rectangular coordinate system in which the Z-axis positive direction is the vertically upward direction.

In the embodiments described below, examples will be described in which the circuit substrate according to the present disclosure is applied to a lighting device, which is an example of the electronic device.

A known circuit substrate includes a substrate made of a ceramic, two wiring layers located on the substrate, a resistor that electrically connects the two wiring layers to each other, and a glass layer that covers the wiring layers and the resistor. In such a circuit substrate, a resistance value of the resistor is adjusted by trimming a part of the resistor by a known technique.

The related art described above has room for further improvement in terms of suppressing peeling of the glass layer. It is expected to provide a circuit substrate and an electronic device that can suppress the peeling of the glass layer.

### First Embodiment

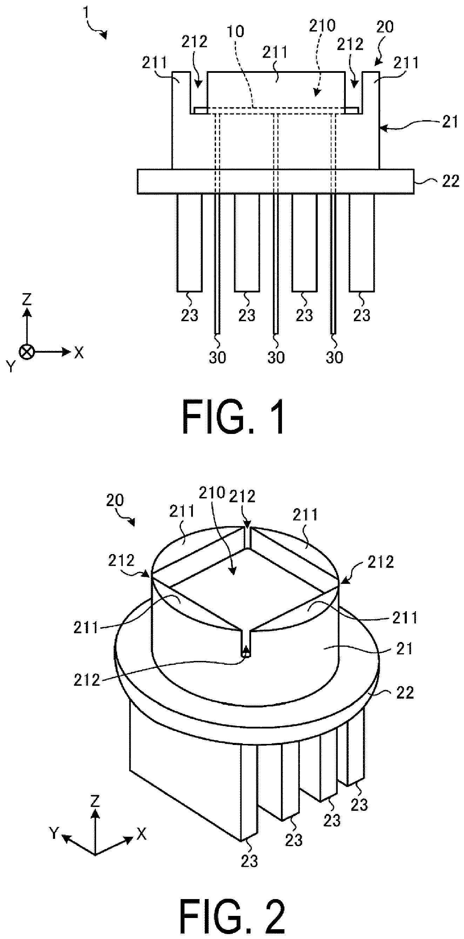

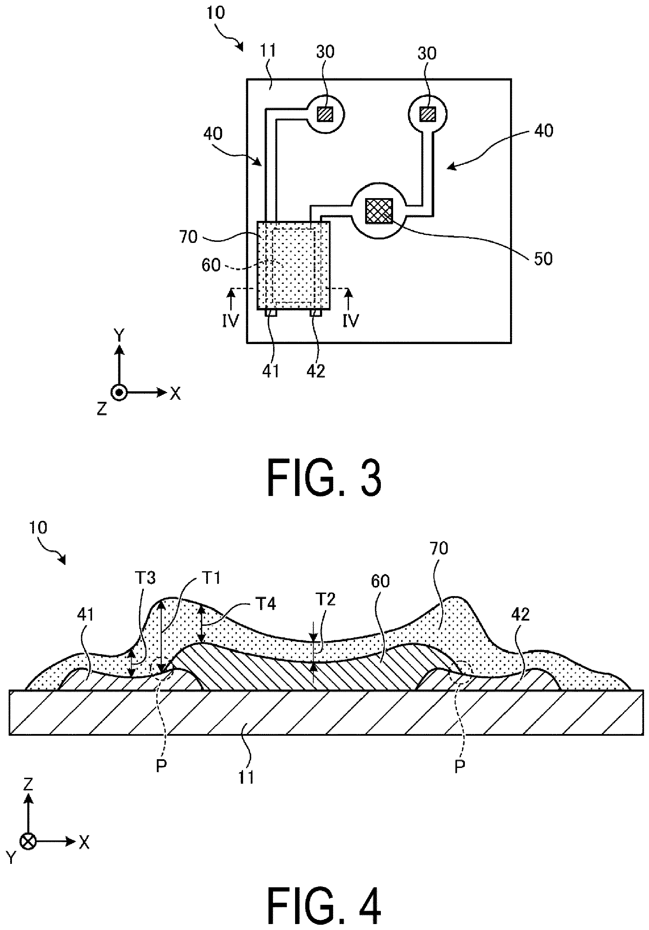

First, a configuration of a lighting device according to a first embodiment will be described with reference to FIGs. 1 to 3. FIG. 1 is a schematic side view illustrating the lighting device according to the first embodiment. FIG. 2 is a schematic perspective view of a socket according to the first embodiment. FIG. 3 is a schematic plan view of a circuit substrate according to the first embodiment.

As illustrated in FIG. 1, a lighting device 1 according to the first embodiment includes a circuit substrate 10, a socket 20 for accommodating the circuit substrate 10, and a plurality of electrically conductive terminals 30 connected to the circuit substrate 10. The lighting device 1 according to the embodiment is used, as, for example, an on-board lighting device. For example, the lighting device 1 is used as a light source such as a rear lamp, a turn lamp, a position lamp, and a fog lamp.

### Socket

As illustrated in FIGs. 1 and 2, the socket 20 may include a housing part 21, a flange part 22, and a plurality of heat dissipating fins 23.

The housing part 21 may be, for example, a bottomed tubular portion having a substantially circular outer shape in plan view. The housing part 21 may be located on a surface opposite a surface on which the plurality of heat dissipating fins 23 are located in the flange part 22 described below. The housing part 21 may include a recessed portion 210 recessed from one end surface of the socket 20, specifically from a surface opposite a surface in contact with the flange part 22 of the housing part 21, toward the other end side of the socket 20. The circuit substrate 10 may be accommodated in the recessed portion 210.

The recessed portion 210 may include a plurality of side wall portions 211. The plurality of side wall portions 211 may have, for example, an arcuate shape in plan view. In this case, the plurality of side wall portions 211 may be arranged along a circumferential direction around the circuit substrate 10 so as to surround the circuit substrate 10. A gap 212 may be provided between each two side wall portions 211 adjacent to each other in the circumferential direction.

The flange part 22 may be, for example, a portion having a disk shape. The flange part 22 may be located between the housing part 21 and the plurality of heat dissipating fins 23. The flange part 22 has a larger diameter than that of the housing part 21, and when the lighting device 1 is inserted into, for example, a mounting hole provided in the vehicle body, the flange part 22 may come into contact with a peripheral edge of the mounting hole. For example, a bayonet (not illustrated) for a twist lock is located on an outer peripheral surface of the housing part 21, and by rotating the socket 20 in a state where the flange part 22 is in contact with the peripheral edge of the mounting hole, the bayonet is fitted into a groove on the vehicle body side, so that the lighting device 1 is in a state of being fixed to the vehicle body.

The plurality of heat dissipating fins 23 may be located on a surface opposite a surface on which the housing part 21 is located in the flange part 22. In this case, heat generated in the circuit substrate 10 is emitted primarily from the plurality of heat dissipating fins 23. Here, the example is given in which the socket 20 includes four heat dissipating fins 23, but the number of the heat dissipating fins 23 of the socket 20 is not limited to four.

Note that a heat transfer member (not illustrated) formed of, for example, a metal such as aluminum may be located between a bottom portion of the recessed portion 210 and the circuit substrate 10. The heat transfer member is located so as to be in contact with the circuit substrate 10 and the bottom portion of the recessed portion 210, and transmits the heat generated in the circuit substrate 10 to the heat dissipating fins 23.

### Circuit Substrate

As illustrated in FIG. 3, the circuit substrate 10 includes a substrate body 11 made of a ceramic. The substrate body 11 may be, for example, a member having a flat plate shape including a first surface that is a circuit forming surface, a second surface located opposite the first surface, and a plurality of third surfaces (side surfaces) respectively connected to the first surface and the second surface. The substrate body 11 is accommodated in the housing part 21 in a state where the second surface faces the bottom surface of the recessed portion 210, in other words, in a state where the first surface that is the circuit forming surface faces the front.

Examples of the ceramic used for the substrate body 11 may include an aluminum oxide-based ceramic, a zirconium oxide-based ceramic, a composite ceramic of aluminum oxide and zirconium oxide, a silicon nitride-based ceramic, an aluminum nitride-based ceramic, a silicon carbide-based ceramic, or a mullite ceramic. Note that the substrate body 11 made of the aluminum oxide-based ceramic has mechanical strength required for the substrate body 11, and has superior workability. The substrate body 11 made of the aluminum nitride-based ceramic has high thermal conductivity, and thus has superior heat radiating properties.

### Wiring

Wirings 40 containing a metal such as copper or silver as a main constituent may be located on the first surface of the substrate body 11. The wirings 40 are electrically connected to electrically conductive terminals 30 via an electrically conductive bonding material (not illustrated) such as a brazing material or a solder.

A light emitting element 50, which is an example of an electronic component, may be located on the wirings 40. The light emitting element 50 is, for example, a light emitting diode (LED), a laser diode (LD), or the like. The wiring 40 electrically connects the electrically conductive terminal 30 and the light emitting element 50 to each other.

A pair of electrodes 41 and 42 may be located in a middle portion of the wiring 40 (a portion between the electrically conductive terminal 30 and the light emitting element 50). The pair of electrodes 41 and 42 may be spaced apart from each other on the substrate body 11. The pair of electrodes 41 and 42 may extend in parallel to each other. Note that an example in which the pair of electrodes 41 and 42 extend in a Y axis direction is illustrated here. The pair of electrodes 41 and 42 are, for example, a part of the wiring 40. The pair of electrodes 41 and 42 may be made of the same material (for example, copper or silver) as that of the wiring 40. Note that, in order to improve a bonding property with the substrate body 11, the pair of electrodes 41 and 42 may contain glass.

### Resistor

A resistor 60 may be located between the pair of electrodes 41 and 42. The resistor 60 has an electric resistance higher than that of the wiring 40 and adjusts voltage applied to the light emitting element 50.

The resistor 60 may contain a conductive component and a resistance value adjustment component. Specifically, the resistor 60 may contain lanthanum hexaboride (LaB₆) as the conductive component. Note that Lanthanum hexaboride need not necessarily be the main constituent of the resistor 60. The resistor 60 may contain, as conductive component other than lanthanum hexaboride, for example, Cu, Ni, Al, Sn, Pd, Ru, RuO₂, Ag, Bi₂Ru₂O₇, Pd₂Ru₂O₆, SrRuO₃, CaRuO₃, BaRuO₃, Ta, TaN, Ta₂N, WC, MoSi₂, TaSi₂, SnO₂, Ta₂O₅, and the like. The resistor 60 may contain, for example, glass as the resistance value adjustment component.

### Glass Layer

A glass layer 70 may be located on the pair of electrodes 41 and 42 and the resistor 60. The glass layer 70 covers the resistor 60 to suppress oxidation of the resistor 60. Thus, the glass layer 70 is located on the resistor 60, so that electrical reliability of the resistor 60 can be improved.

As the glass layer 70, for example, any of R₂O-B₂O₃-SiO₂ System (R: alkali metal element), R₂O-SiO₂-B₂O₃-Bi₂O₃ System (R: alkali metal element), R'O-B₂O₃-SiO₂(R': alkaline earth metal element) may be used as a main constituent. The glass layer 70 may contain, for example, titanium oxide (TiOz) and zirconium oxide (ZrO₂). In this case, reflectance of the glass layer 70 can be improved.

Here, a specific configuration of the glass layer 70 according to the first embodiment will be described with reference to FIG. 4. FIG. 4 is a schematic cross-sectional view taken along line IV-IV in FIG. 3.

As illustrated in FIG. 4, the resistor 60 is located over the pair of electrodes 41 and 42. The glass layer 70 may be located so as to entirely cover the pair of electrodes 41 and 42 and the resistor 60.

Here, the inventor of the present application confirmed that, in the circuit substrate including the resistor containing lanthanum hexaboride, peeling of the glass layer frequently occurs in the vicinity of an outer peripheral portion of the resistor, which is a portion where the resistor and the electrodes overlap each other, as compared with other portions. This is considered to be due to an influence of a reduction action of lanthanum hexaboride. In other words, lanthanum hexaboride is known as a thermal electron emitter and emits electrons when heated. The emitted electrons are considered to reduce the surrounding metal components to cause the peeling of the glass layer to occur.

Specifically, when the circuit substrate is heated in a manufacturing process or the like, a temperature in the vicinity of the electrodes containing Cu having a relatively high thermal conductivity becomes relatively higher than the other portions. As a result, the temperature at the outer peripheral portion of the resistor becomes higher than the temperature at the other portions of the resistor. As a result, more electrons are emitted from the outer peripheral portion of the resistor.

In a region of the electrodes in contact with the resistor, electrons emitted from the resistor are supplied to the electrodes, so that the following reduction reaction occurs in the electrodes.

CuO + 2e⁻ → Cu + O²⁻

Cu simple substance generated by the reduction reaction has a lower affinity with glass, which is an oxide, than CuO. Thus, in the region of the electrodes in contact with the resistor, in other words, in the vicinity of the outer peripheral portion of the resistor, adhesion strength between the electrodes and the glass layer is weakened, and thus the glass layer is easily peeled off from the electrodes.

In a region of the glass layer in contact with the resistor, particularly in the vicinity of the outer peripheral portion of the resistor from which a large number of electrons are emitted, the electrons emitted from the resistor are supplied to the glass layer, so that the following reduction reaction occurs in the glass layer.

SiO₂ + 4e⁻ → Si + 2O²⁻

The Si simple substance generated by the above-described reduction reaction has a lower affinity with the resistor (lanthanum hexaboride) than SiO₂. Thus, the adhesion strength between the resistor and the glass layer is weakened at the outer peripheral portion of the resistor, and as a result, the glass layer is easily peeled off from the resistor.

In the circuit substrate 10 according to the first embodiment, a thickness of the glass layer 70 at the outer peripheral portion of the resistor 60 may be made greater than a thickness of the glass layer 70 at the center portion of the resistor 60. Thus, the peeling of the glass layer 70 can be suitably suppressed.

In other words, by, for example, making the glass layer 70 thick as a whole, the peeling of the glass layer 70 can be also suppressed to some extent. This is because a weight of the glass layer 70 increases by an amount corresponding to an increase in the thickness of the glass layer 70, so that it is easy to physically suppress the peeling.

On the other hand, thermal stress due to a difference in thermal expansion coefficient between the electrode 41, the electrode 42, and the resistor 60 and the glass layer 70 increases as the thickness of the glass layer 70 increases. An effect of suppressing the peeling by the weight of the glass layer 70 described above may be weakened due to the thermal stress.

Here, the weight of the glass layer 70 at the center portion of the resistor 60 is not directly applied to the outer peripheral portion of the resistor 60. In other words, an increase in the thickness of the glass layer 70 at the center portion of the resistor 60 does not significantly contribute to the effect of suppressing the peeling. In addition, the thermal stress is increased by an amount corresponding to the increase in the thickness of the glass layer 70 at the center portion of the resistor 60, and as a result, the effect of suppressing the peeling by the weight of the glass layer 70 is rather weakened.

On the other hand, according to the circuit substrate 10 of the first embodiment, the thickness of the glass layer 70 at the center portion of the resistor 60 is made relatively thin, so that the thermal stress can be suppressed from an unnecessary increase. Thus, the circuit substrate 10 according to the first embodiment can suitably suppress the peeling of the glass layer 70.

In the circuit substrate, in order to adjust the resistance value of the resistor, a trimming process may be performed on the resistor, for example, after product shipment. The trimming process is a method of adjusting the resistance value of the resistor by forming a groove at the center portion of the resistor or in the vicinity thereof with a laser or the like to narrow a resistance width of the resistor. According to the circuit substrate 10 of the first embodiment, the thickness of the glass layer 70 at the center portion of the resistor 60 is made relatively thin, so that the peeling of the glass layer 70 can be suitably suppressed while ease of the trimming process is ensured. According to the circuit substrate 10 of the first embodiment, the thickness of the glass layer 70 at the center portion of the resistor 60 is made relatively thin, so that a material cost required for the glass layer 70 can be suppressed.

Note that, in order to make the thickness of the glass layer 70 at the outer peripheral portion of the resistor 60 relatively thick, the number of times of applying the glass layer 70 onto the outer peripheral portion of the resistor 60 may be relatively increased. For example, after one layer of glass is applied onto the pair of electrodes 41 and 42 and the resistor 60, another layer of the glass may be applied onto the outer peripheral portion of the resistor 60. At this time, by using a mask member including an opening at a position corresponding to the outer peripheral portion of the resistor 60, the glass can be suitably applied only to the outer peripheral portion of the resistor 60.

The thickness of the glass layer 70 will be described more specifically. As illustrated in FIG. 4, a thickness T1 of the glass layer 70 at a position where three of the electrode 41 (42), the resistor 60, and the glass layer 70 are in contact with each other, specifically at a peripheral edge P of the resistor 60 located on the electrode 41 (42) may be greater than a thickness T2 of the glass layer 70 at the center portion of the resistor 60. The peeling due to the thermal stress is more likely to occur at the position where the three of the electrode 41 (42), the resistor 60, and the glass layer 70 are in contact with each other than at other positions. The thickness of the glass layer 70 is made thick, in particular, at the position where the above-described three are in contact with each other among the outer peripheral portion of the resistor 60, so that the peeling of the glass layer 70 can be further suitably suppressed.

A thickness T3 of the glass layer 70 located only on the electrode 41 (42) may be less than a thickness T4 of the glass layer 70 at the outer peripheral portion of the resistor 60. Specifically, the thickness T3 is a thickness of the glass layer 70 at the center portion of the electrode 41 (42), for example. The thickness T4 is, for example, a thickness of the glass layer 70 at a position where a total thickness of the electrode 41 (42) and the resistor 60 is the thickest. The position where the total thickness of the electrode 41 (42) and the resistor 60 is the thickest is a place to which a stress due to repeated thermal expansion and thermal contraction is most likely to be applied. By increasing the thickness T4 of the glass layer 70 at such a position, the peeling of the glass layer 70 can be suitably suppressed. The electrode 41 (42) containing Cu has higher thermal conductivity than the resistor 60. Thus, by making the thickness T3 of the glass layer 70 located only on the electrode 41 (42) relatively thin, heat transmitted from the resistor 60 to the electrode 41 (42) can be efficiently emitted to the outside.

As an example, the thickness of the electrodes 41 and 42 may be not less than 10 µm and not more than 30 µm, the thickness of the resistor 60 may be not less than 15 µm and not more than 35 µm, and the thickness of the glass layer 70 may be not less than 10 µm and not more than 40 µm. The thicknesses of the electrodes 41 and 42, the resistor 60, and the glass layer 70 can be obtained by, for example, cutting the circuit substrate 10 so as to obtain cross sections of the electrodes 41 and 42, the resistor 60, and the glass layer 70, and observing a cross-sectional plane thereof using a scanning electron microscope (SEM).

A void ratio of the resistor 60 at the center portion may be higher than a void ratio of the resistor 60 at the outer peripheral portion. As described above, in the vicinity of the center portion of the resistor 60, the trimming process may be performed. By making the void ratio of the resistor 60 at the center portion higher than the void ratio at the outer peripheral portion, the ease of the trimming process can be enhanced.

The resistor 60 may include voids at the outer peripheral portion. When the voids are present at the outer peripheral portion of the resistor 60, the thermal stress generated in the vicinity of the outer peripheral portion of the resistor 60 is relaxed, so that the reliability of the circuit substrate 10 can be improved.

Note that the resistor 60 is formed after the electrode 41 (42) is formed on the substrate body 11. When the resistor 60 is formed, the electrode 41 (42) is heated, so that gas present in the resistor 60 in the vicinity of the electrode 41 (42) is easily released or sintering is promoted, and as a result, the void ratio of the resistor 60 at the outer peripheral portion is considered to become relatively low.

A void diameter of the resistor 60 at the center portion may be larger than a void diameter of the resistor 60 at the outer peripheral portion. By making the void diameter of the resistor 60 at the center portion larger than the void diameter at the outer peripheral portion, the ease of the trimming process can be enhanced.

The void ratio of the resistor 60 can be obtained in the following manner, for example. First, the circuit substrate 10 is cut so as to obtain a cross section of the resistor 60, and a cross-sectional plane thereof is observed using the SEM to capture an image at a predetermined magnification. By performing image processing on the captured image (SEM image) to calculate the total area of the voids relative to the entire area of the image, and thus the void ratio of the resistor 60 can be obtained.

As an example, the void ratio of the resistor 60 may be not less than 5 area% and not more than 40 area%. As an example, the void diameter (equivalent circle diameter) of the resistor 60 at the center portion may be not less than 5 µm and not more than 11 µm, and the void diameter (equivalent circle diameter) of the resistor 60 at the outer peripheral portion may be not less than 3 µm and not more than 6 µm. The equivalent circle diameters of the voids can also be obtained by analyzing the SEM image. For example, the voids are traced in the SEM image, an average value of the equivalent circle diameters of the voids may be calculated by performing image analysis on the traced image by using a particle analysis method of the image analysis software "Azo-kun" (trade name, manufactured by Asahi Kasei Engineering Corporation, and, hereinafter, when the image analysis software "Azo- kun" is mentioned in the following, it refers to the image analysis software manufactured by Asahi Kasei Engineering Corporation).

### Second Embodiment

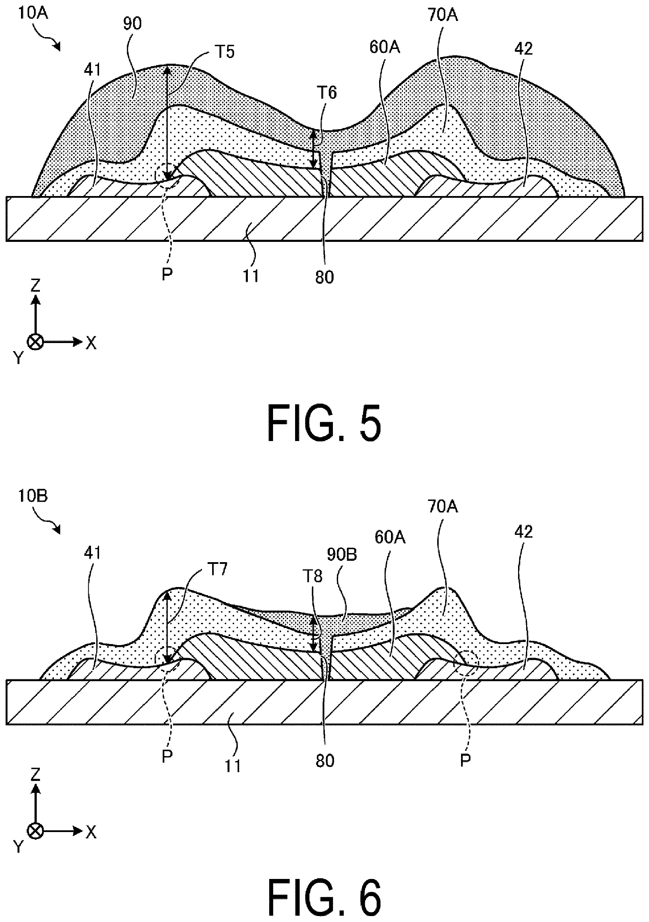

A configuration of a circuit substrate according to a second embodiment will be described with reference to FIG. 5. FIG. 5 is a schematic cross-sectional view of the circuit substrate according to the second embodiment.

As illustrated in FIG. 5, a circuit substrate 10A according to the second embodiment may include a resistor 60A and a glass layer 70A. In the resistor 60A and the glass layer 70A, a trimming groove 80 vertically penetrating the resistor 60A and the glass layer 70A may be formed. The trimming groove 80 is formed to adjust the resistance value of the resistor 60A.

The trimming groove 80 may be located at a center portion of the resistor 60A. The center portion of the resistor 60A means a center portion in the cross-sectional view illustrated in FIG. 5, in other words, a center portion in an arrangement direction (here, an X axis direction) of the pair of electrodes 41 and 42. A position of the trimming groove 80 need not be exactly at the center of the resistor 60A, and may be slightly shifted from the center of the resistor 60A. The trimming groove 80 extends linearly in parallel to the pair of electrodes 41 and 42, for example. The trimming groove 80 may have, for example, an L-shape including a portion linearly extending in parallel to the pair of electrodes 41 and 42 and a portion extending in a direction orthogonal to the pair of electrodes 41 and 42.

The circuit substrate 10A according to the second embodiment may include a resin layer 90. In the second embodiment, the resin layer 90 covers all of the pair of electrodes 41 and 42, the resistor 60A, and the glass layer 70A. Note that the inside of the trimming groove 80 is filled with resin.

When the resin layer 90 is further located on the glass layer 70A as described above, the effect of physically suppressing the peeling can be enhanced by the weight of the resin layer 90.

In the circuit substrate 10A according to the second embodiment, a total thickness T5 of the glass layer 70A and the resin layer 90 at the outer peripheral portion of the resistor 60A, specifically at the peripheral edge P of the resistor 60 may be greater than a total thickness T6 of the glass layer 70A and the resin layer 90 at the center portion of the resistor 60A. As described above, the total thickness T6 of the glass layer 70A and the resin layer 90 at the center portion of the resistor 60A is made relatively thin, and thus the thermal stress can be suppressed from an unnecessary increase, so that the peeling of the glass layer 70A can be suitably suppressed.

Note that, as an example, a thickness of the resin layer 90 is not less than 10 µm and not more than 40 µm. The thicknesses of the resin layer 90 can be obtained by, for example, cutting the circuit substrate 10A so as to obtain cross sections of the electrodes 41 and 42, the resistor 60A, the glass layer 70A and the resin layer 90, and observing a cross-sectional plane thereof using the SEM.

### Third Embodiment

A configuration of a circuit substrate according to a third embodiment will be described with reference to FIG. 6. FIG. 6 is a schematic cross-sectional view of the circuit substrate according to the third embodiment.

As illustrated in FIG. 6, the circuit substrate 10B according to the third embodiment may include a resin layer 90B. The resin layer 90B according to the third embodiment may cover only a region of a part of the pair of electrodes 41 and 42, the resistor 60A, and the glass layer 70A, the region including the center portion of the resistor 60A. Specifically, the resin layer 90B may be located inside a region sandwiched between the peripheral edge P of the resistor 60A located on the one electrode 41 and the peripheral edge P of the resistor 60A located on the other electrode 42.

As described above, the resin layer 90B only needs to cover at least the trimming groove 80, and need not necessarily cover the entirety of the pair of electrodes 41 and 42, the resistor 60A, and the glass layer 70A.

In the circuit substrate 10B according to the third embodiment, a total thickness T7 (corresponding to the thickness T1 of the glass layer 70A at the peripheral edge P) of the glass layer 70A and the resin layer 90B at the peripheral edge P of the resistor 60 at the electrode 41 (42) may be greater than a total thickness T8 of the glass layer 70A and the resin layer 90B at the center portion of the resistor 60A. As described above, the total thickness T8 of the glass layer 70A and the resin layer 90B at the center portion of the resistor 60A is made relatively thin, and thus the thermal stress can be suppressed from an unnecessary increase, so that the peeling of the glass layer 70A can be suitably suppressed.

As described above, the circuit substrate (as an example, the circuit substrate 10, 10A, and 10B) according to the embodiment includes the substrate body (as an example, the substrate body 11), the pair of electrodes (as an example, the pair of electrodes 41 and 42), the resistor (as an example, the resistor 60 and 60A), and the glass layer (as an example, the glass layer 70 and 70A). The substrate body is made of a ceramic. The pair of electrodes are spaced apart from each other on the substrate body. The resistor is located over the pair of electrodes. The glass layer covers the pair of electrodes and the resistor. The resistor contains lanthanum hexaboride. A thickness of the glass layer at an outer peripheral portion of the resistor is greater than a thickness of the glass layer at a center portion of the resistor.

The circuit substrate (as an example, the circuit substrate 10A and 10B) according to the embodiment includes the substrate body (as an example, the substrate body 11), the pair of electrodes (as an example, the pair of electrodes 41 and 42), the resistor (as an example, the resistor 60A), the glass layer (as an example, the glass layer 70A) and the resin layer (as an example, the resin layer 90). The substrate body is made of a ceramic. The pair of electrodes are spaced apart from each other on the substrate body. The resistor is located over the pair of electrodes and includes the trimming groove (as an example, the trimming groove 80). The glass layer covers the pair of electrodes and the resistor. The resin layer covers at least the trimming groove. The resistor contains lanthanum hexaboride. A thickness of the glass layer at an outer peripheral portion of the resistor is greater than a thickness of the glass layer at a center portion of the resistor.

Thus, according to the circuit substrate of the embodiment, the peeling of the glass layer can be suitably suppressed.

Note that the electronic device on which the circuit substrate according to the present disclosure is mounted is not limited to the lighting device and is applicable to various electronic devices other than the lighting device.

For example, the electronic device according to the present disclosure is applicable to a flowmeter, a display monitor mounted on such as a smart watch, a power module such as an inverter, a converter, or the like, a power semiconductor such as on-board power control unit, battery components, secondary battery components, air conditioning systems (particularly for on-board applications), optical communication devices, laser projectors such as laser cinemas, laser machines, various sensor components, optical pickup components used for reading and writing a digital versatile disk (DVD) or a compact disk (CD), laser diode components, laser diode components, a central processing unit (CPU), a graphics processing unit (GPU), a tensor processing unit (TPU), and the like.

Further effects and variations can be readily derived by those skilled in the art. Thus, a wide variety of aspects of the present invention are not limited to the specific details and representative embodiments represented and described above. Accordingly, various changes are possible without departing from the spirit or scope of the general inventive concepts defined by the appended claims and their equivalents.

### REFERENCE SIGNS

1 Lighting device
10 Circuit substrate
11 Substrate body
20 Socket
21 Housing part
22 Flange part
23 Heat dissipating fin
30 Electrically conductive terminal
40 Wiring
41, 42 Electrode
50 Light emitting element
60 Resistor
70 Glass layer
80 Trimming groove
90 Resin layer

## Claims

1. A circuit substrate comprising:
a substrate body made of a ceramic;
a pair of electrodes spaced apart from each other on the substrate body;
a resistor located over the pair of electrodes; and
a glass layer configured to cover the pair of electrodes and the resistor, wherein
the resistor contains lanthanum hexaboride, and
a thickness of the glass layer at an outer peripheral portion of the resistor is greater than a thickness of the glass layer at a center portion of the resistor.

2. A circuit substrate comprising:
a substrate body made of a ceramic;
a pair of electrodes spaced apart from each other on the substrate body;
a resistor located over the pair of electrodes and comprising a trimming groove;
a glass layer configured to cover the pair of electrodes and the resistor; and
a resin layer configured to cover at least the trimming groove, wherein
the resistor contains lanthanum hexaboride, and
a thickness of the glass layer at an outer peripheral portion of the resistor is greater than a thickness of the glass layer at a center portion of the resistor.

3. The circuit substrate according to claim 1 or 2, wherein
a thickness of the glass layer at a position where the electrode, the resistor, and the glass layer are in contact with each other is greater than a thickness of the glass layer located at the center portion of the resistor.

4. The circuit substrate according to claim 2, wherein
a total thickness of the glass layer and the resin layer at a position where the electrode, the resistor, and the glass layer are in contact with each other is greater than a total thickness of the glass layer and the resin layer located at the center portion of the resistor.

5. The circuit substrate according to any one of claims 1 to 4, wherein
a thickness of the glass layer located only on the electrode is less than a thickness of the glass layer at the outer peripheral portion of the resistor.

6. The circuit substrate according to any one of claims 1 to 5, wherein
a void ratio of the resistor at the center portion is greater than a void ratio of the resistor at the outer peripheral portion.

7. The circuit substrate according to any one of claims 1 to 6, wherein
a void diameter of the resistor at the center portion is larger than a void diameter of the resistor at the outer peripheral portion.

8. An electronic device comprising:
the circuit substrate according to any one of claims 1 to 7; and
an electronic component located on the substrate body and connected to the pair of electrodes.
